(19) Europäisches Patentamt

European Patent Office

Office européen des brevets

(11) Veröffentlichungsnummer: **0 346 800 B1**

(12)

# EUROPÄISCHE PATENTSCHRIFT

(45) Veröffentlichungstag der Patentschrift: **02.02.94**

(21) Anmeldenummer: **89110601.5**

(22) Anmeldetag: **12.06.89**

(51) Int. Cl.⁵: **H04L 27/14**, H03H 17/06

(54) **Digitale Filterweiche.**

(30) Priorität: **15.06.88 DE 3820386**

(43) Veröffentlichungstag der Anmeldung:
**20.12.89 Patentblatt 89/51**

(45) Bekanntmachung des Hinweises auf die
Patenterteilung:
**02.02.94 Patentblatt 94/05**

(84) Benannte Vertragsstaaten:
**AT BE DE FR GB IT LU NL SE**

(56) Entgegenhaltungen:
**EP-A- 0 208 982**

(73) Patentinhaber: **SIEMENS AKTIENGESELL-
SCHAFT**
**Wittelsbacherplatz 2**
**D-80333 München(DE)**

(72) Erfinder: **Winkelmann, Rudolf, Dipl.-Ing. (TU)**
**Konrad-Witz-Strasse 14**
**D-8000 München 71(DE)**

Rank Xerox (UK) Business Services
(3.10/3.09/3.3.3)

EP 0 346 800 B1

**Beschreibung**

Die Erfindung betrifft eine digitale Filterweiche gemäß dem Oberbegriff des patentanspruches 1.

Die Erfindung beschreibt eine digitale Realisierung eines FSK-(Frequency-Shift-Keying) Datenempfängers zur Demodulation von frequenzumgetasteten Datensignalen.

Die gleichstromfreie Übertragung digitaler Daten über große Entfernungen erfolgt im allgemeinen mit Hilfe der FSK-Modulation, wobei - für die Dauer eines zu übertragenden Bits - dem logischen Zustand der "0" Schwingungszüge der Trennfrequenzlage (Space-Frequency), dem der logischen "1" Schwingungszüge der Zeichenfrequenzlage (Mark-Frequency) gesendet werden.

Die hier beschriebene Anordnung eines Datenempfängers dient dazu, ein frequenzumgetastetes Datensignal wieder in das Basisband umzusetzen, d.h., die in ihm enthaltene digitale Information wieder rückzugewinnen.

Aus der Literatur sind verschiedene Verfahren zur Demodulation von FSK-Signalen bekannt, die sich im wesentlichen in drei Klassen einteilen lassen:

1. dem digitalen Nulldurchgangsdetektor für Übertragungsgeschwindigkeiten bis etwa 600 Bd,
2. dem digitalen Flankendemodulator,
3. dem FM-Gegentaktdiskriminator nach der EP-OS 208 982.

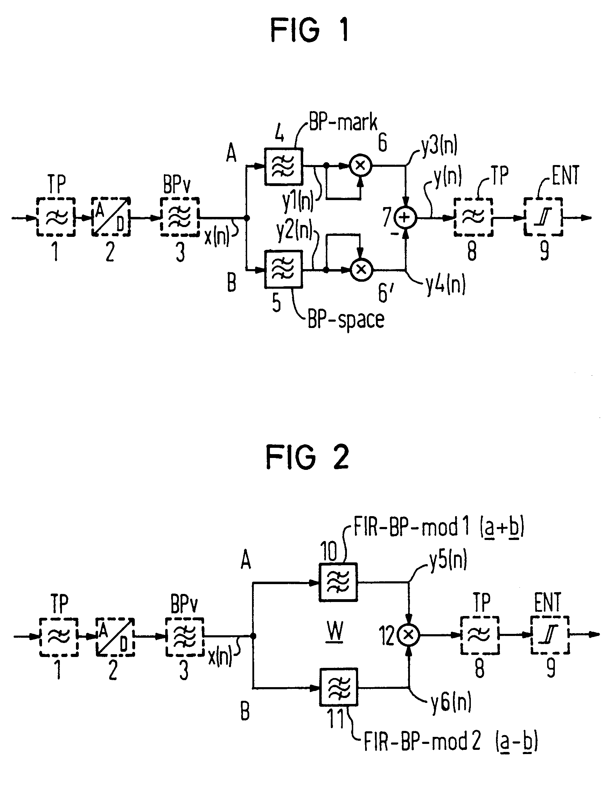

Dazu zeigt Fig. 1 wie ein frequenzumgetastetes Datensignal zunächst analog vorgefiltert (Antialiasing-Tiefpass) und analog/digital gewandelt wird. Danach wird das (jetzt digitalisierte) FSK-Signal in einem Vorfilter BPv (digitaler Bandpass) grob von Geräusch- und Nachbarkanalstörungen befreit. Das bandgefilterte FSK-Signal x(n) verzweigt anschließend in zwei, parallel zueinander angeordnete, digitale Separierungsbvankpässe BP_mark und BP_space.

Ein Separierungsbandpass (BP_space) ist auf die Trennfrequenz, der andere Separierungsbandpass (BP_mark) auf die Zeichenfrequenz abgestimmt.

Zur Demodulation werden die Ausgangssignale y1(n) und y2(n) beider Separierungsbandpässe jeweils quadriert. Schließlich werden die quadrierten Signale y3(n) = y1(n) *y1(n) und y4(n) = y2(n) *y2(n) voneinander subtrahiert und ergeben das Signal y(n), welches durch den nachfolgenden digitalen Tiefpaß TP und Entscheider ENT weiterverarbeitet wird.

Dei Demodulation des FSK-Signals erfolgt nicht durch Gleichrichtung, sondern durch Quadrierung, um nichtkorregierbare Verzerrungen durch Spektralkomponenten jenseits der halben Abtastfrequenz zu vermeiden.

Der Erfindung liegt die Aufgabe zugrunde, Möglichkeiten anzugeben, um den Signalflußgraphen der digitalen Filterweiche nach Fig. 1 noch zu vereinfachen und dadurch auch zu einfacheren Schaltungen zu kommen.

Diese Aufgabe wird gemäß der Erfindung nach den kennzeichnenden Merkmalen des Patentanspruches 1 gelöst.

Eine vorteilhafte Ausgestaltung ist im patentanspruch 2 angegeben.

Anhand vom Ausführungsbeispiel wird nachstehend die Erfindung noch näher erläutert.

Es zeigen in der Zeichnung

FIG 1 wie vorstehend schon erwähnt, die Funktionsweise einer digitalen Filterweiche nach der EP-A-208 982.

FIG 2 eine vereinfachte Realisierung einer digitalen Filterweiche unter Verwendung eines Multiplizierers und Transversalfiltern als Bandpässe,

FIG 3 den Signalflußgraphen für ein FIR-Filter (Finit Impuls Response) vom Grad N,

FIG 4 den Signalflußgraphen für die vereinfachte Realisierung der digitalen Filterweiche gemäß Fig. 2.

Um die für die Erfindung erforderlichen Beschreibungs- und Berechnungsgrundlagen übersichtlicher darzustellen, wird in Fig. 1 auf die in der EP-A-208 982 beschriebene Filterweiche noch im einzelnen eingegangen. Dabei ist am Eingang der Schaltung ein analoger Tiefpaß 1 vorgesehen, dem ein Analog-Digitalwandler 2 folgt. Nachgeschaltet ist anschließend ein Vorfilter 3, an dessen Ausgang das Signal x(n) auftritt. Das Signal wird in 2 Wege A und B aufgespalten, und in einem Summierer 7 wieder zusammengefaßt. Es tritt aus dem Summierer 7 das Signal y(n) aus und durchläuft den Tiefpaß 8, und anschließend ein Entscheider 9. An diesem Entscheider 9 steht dann das Ausgangssignal der digitalen Filterweiche zur Verfügung. Im Weg A ist vorgesehen ein Bandpaß 4 mit dem Koeffizientenvektor $\underline{a}$, der auf die Zeichenfrequenz abgestimmt ist, so daß das Signal y1(n) aus dem Bandpaß 4 austritt. Dieses Signal wird in einem Quadrierer 6 quadriert, was dadurch kenntlich gemacht ist, daß das Signal y1(n) den 2 Eingängen des Quadrierers 6 zugeführt wird. Das quadrierte Ausgangssignal y3(n) wird dem Summierer 7 zugeführt. In entsprechender Weise wird im Weg B zunächst der Bandpaß 5 mit dem Koeffizientenvektor $\underline{b}$ durchlaufen, der auf die Trennfrequenz abgestimmt ist. Das Ausgangssignal y2(n) wird einem Quadrierer 6′ zugeführt,

2

was ebenfalls in der Weise kenntlich gemacht ist, daß das Ausgangssignal y2(n) beiden Eingängen des Quadrierers 6' zugeführt wird. Das Ausgangssignal des Quadrierers 6' ist mit y4(n) bezeichnet. Dieses Ausgangssignal wird invertiert dem Summierer 7 zugeführt.

Im Ausführungsbeispiel von Fig. 2 wird auf die Beschreibung von Fig. 1 zurückgegriffen und es sind gleiche Schaltungsbestandteile mit gleichen Bezugsziffern bezeichnet. Das Signal x(n) wird wiederum in die Wege A und B aufgespalten. Im Weg A ist vorgesehen ein Bandpaß 10, dessen Ausgangssignal mit y5(n) bezeichnet ist. Entsprechend ist im Weg B ein Bandpaß 11 vorgesehen, dessen Ausgangssignal mit y6(n) bezeichnet ist. Diese beiden Ausgangssignale werden in einem Multiplizierer 12 zusammengefaßt, dessen Ausgangssignal wiederum den Tiefpaß 8 und den Entscheider 9 durchlaufen. Wesentlich ist nun, daß die Bandpässe 10 und 11 als Transversalfilter ausgebildet sind, und daß von transversalen Bandpässen 4 und 5 ausgegangen wird. Die Bemessung der Bandpässe 10 und 11 ist derart vorgenommen, daß sich ihre Koeffizienten aus der Summe (a + b) beziehungsweise aus der Differenz (a - b) der Koeffizienten der ursprünglichen transversalen Bandpässe 4 und 5 ergeben. Kenntlich gemacht ist dies durch den Hinweis FIR-BP__modl beziehungsweise den Hinweis FIR-BP__mod2, wobei auf die Transversalfilter ("Finit Impulse Response"-Filter) hingewiesen wird.

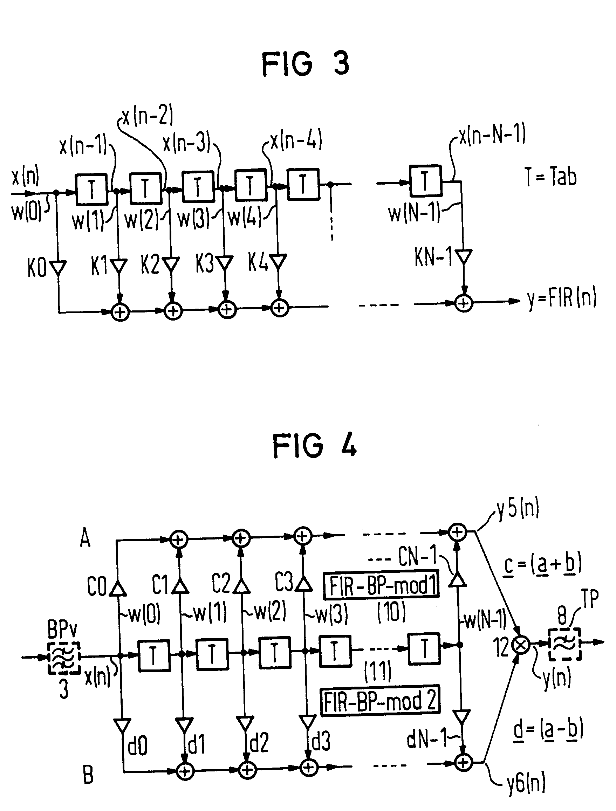

Fig. 3 zeigt den Signalflußgraphen für ein Transversalfilter vom Grad N. Das Eingangssignal x(n) durchläuft eine Verzögerungskette mit den Verzögerungselementen T. Die einzelnen verzögerten Eingangswerte (zum Beispiel x(n-4)) sind ebenfalls kenntlich gemacht, genauso wie die entsprechenden Zustandsgrößen, zum Beispiel w(0) und w(4). Entsprechend sind die einzelnen Filterkoeffizienten mit k0..., k4..., kN-1 bezeichnet. Die Signale werden in Addierern (+) jeweils aufsummiert und stehen am Ausgang als Signal y__FIR(n) zur Verfügung.

Für den Signalflußgraphen von Fig. 4 kann die zu Fig. 2 gegebene Erläuterung unmittelbar herangezogen werden. Zu erkennen sind die Zustandsgrößen w(0) bis w(N-1), die Filterkoeffizienten c0 bis cN-1 im Weg A und die Filterkoeffizienten d0 bis dN-1 im Weg B. Die in den Wegen A und B jeweils entsprechend in den Summierern (+) aufakkumulierten Signale y5(n) und y6(n) werden am Multiplizierer 12 zusammengefaßt und stehen gefiltert am Ausgang von Tiefpaß 8 zur Verfügung. Zu erkennen sind auch die Filterkoeffizientenvektoren c = (a + b) im Weg A beziehungsweise d = (a - b) im Weg B.

Zur besseren Erläuterung sei noch folgendes ausgeführt.

Der Signalflußgraph der digitalen Filterweiche nach Fig. 1 kann unter bestimmten Voraussetzungen weiter vereinfacht werden:

Sind beide Separierungsbandpässe BP__mark und BP__space FIR-Filter vom Grad N, wie in Fig. 2 gezeigt, können Quadrierung und anschließende Subtraktion auf EINE EINZIGE Multiplikation zurückgeführt werden. Darüberhinaus ist für BEIDE Separierungsbandpässe nur EIN gemeinsamer Zustandsspeicher w erforderlich.

Fig. 3 zeigt den Signalflussgraphen für ein FIR-Filter vom Grad N. Solche transversalen Filterstrukturen lassen sich z.B. in einem digitalen Signalprozessor besonders einfach realisieren. Die Übertragungsfunktion eines FIR-Filters läßt sich allgemein angeben zu:

$$\mathrm{H\_FIR}(z) = \sum_{i=0}^{N-1} k(i) * z^{-i}$$

mit

$z = e^{j2\pi f/fab}$

fab = 1/Tab ... Abtastfrequenz

N ... Filtergrad

k(i) ... FIR-Filterkoeffizienten.

Das Ausgangssignal y__FIR zum Zeitpunkt n*Tab zu:

$y(n) = (\underline{k}^T * \underline{w})$

mit $\underline{k}^T$ = [k0, k1, k2, ... kN-1] FIR-Koeffizientenvektor

$\underline{w}^T$ = [xn, xn-1, xn-2 ... xn-N-1] Zustandsvektor

x(n) ... Eingangswert z.Ztpkt. n*Tab

Die Übertragungsfunktion beider FIR-Separierungsbandpässe nach Fig. 2 läßt sich somit angeben zu:

$$H\ BP\_mark\ (z)\ =\ \sum_{i=0}^{N-1} a(i) * z^{-i}$$

$$H\ BP\_space(z)\ =\ \sum_{i=0}^{N-1} b(i) * z^{-i}$$

wobei
   a(i) ... FIR-Filterkoeffizienten BP__mark
   b(i) ... FIR-Filterkoeffizienten BP__space
mit

   $\underline{a}^T$ = [a0, a1, a2, ... aN-1] Koeffizientenvektor BP__mark
$\underline{b}^T$ = [b0, b1, b2, ... bN-1] Koeffizientenvektor BP__space
$\underline{w}^T$ = [xn, xn-1, xn-2 ... xn-N-1] GEMEINSAMER Zustandsvektor
x(n) Eingangssample z.Ztpkt. n
ergibt sich

y1(n) = $(\underline{a}^T * \underline{w})$ ;     y2(n) = $\underline{b}^T * \underline{w})$

daraus

y3(n) = $(\underline{a}^T * \underline{w}) * (\underline{a}^T * \underline{w})$ ;     y4(n) = $(\underline{b}^T * \underline{w}) * (\underline{b}^T * \underline{w})$

schliesslich

y(n) = y3(n) - y4(n) = $(\underline{a}^T * \underline{w})*(\underline{a}^T * \underline{w})$ - $(\underline{b}^T * \underline{w}) * (\underline{b}^T * \underline{w})$
y(n) = $(\underline{a}-\underline{b})^T * \underline{w} * (\underline{a}+\underline{b})^T * \underline{w}$ .

   Die Koeffizientenvektoren $\underline{c}$ und $\underline{d}$ der so neu gewonnenen, modifizierten FIR-Separierungsbandpässe BP__mod1 und BP__mod2 erhält man zu:

$\underline{c}^T$ = $(\underline{a}-\underline{b})^T$ = [a0-b0, a1-b1, ... a(N-1)-b(N-1)] und
$\underline{d}^T$ = $(\underline{a}+\underline{b})^T$ = [a0+bo, a1+b1, ... a(N-1)+b(N-1)]

deren Uebertragungsfunktionen zu:

$$H\ BP\_mod1\ (z)\ =\ \sum_{i=0}^{N-1} (ai-bi) * z^{-i}$$

$$H\ BP\_mod2\ (z)\ =\ \sum_{i=0}^{N-1} (ai+bi) * z^{-i}$$

In Fig. 2 ist das Funktionsschaltbild für die vereinfachte Realisierung dargestellt, in Fig. 4 der zugehörige Signalfluß graph:
   Das vorselektierte, zu demodulierende, Eingangssignal x(n) wird gleichzeitig den zwei "modifizierten" digitalen FIR-Separierungsbandpässen BP__mod1 und BP__mod2 zugeführt.
   Deren Ausgangssignale y5(n) und y6(n) werden nur noch miteinander multipliziert und ergeben das Ausgangssignal y(n), das nachfolgend von einem digitalen Tiefpaß TP und dem Entscheider ENT weiterverarbeitet werden kann.

4

**Patentansprüche**

1. Digitale Filterweiche, insbesondere für einen Datenempfänger, die einen Analog-Digital-Wandler (2) enthält und bei der die Digitalsignale nach dem Analog-Digitalwandler (2) und einem Vorfilter (3) in einen ersten Weg (A) und in einen zweiten Weg (B) durch entsprechend zugeordnete digitale Bandpässe (4, 5) aufgespalten werden,
   **dadurch gekennzeichnet,**
   daß beide Bandpässe (4, 5) als Transversalfilter (10, 11) ausgebildet sind,
   und daß diese Transversalfilter (10, 11) derart bemessen sind, daß sich ihre Koeffizienten aus der Summe bzw. aus der Differenz der Koeffizienten der beiden transversalen Bandpässe (4, 5) ergeben, und daß beide Wege (A, B) über einen Multiplizierer (12) zusammengeschaltet sind.

2. Digitale Filterweiche nach Anspruch 1,
   **dadurch gekennzeichnet,**
   daß für beide transversalen Bandpässe (10, 11) nur ein gemeinsamer Zustandsspeicher (w, Laufzeitkette) vorgesehen ist.

**Claims**

1. Digital separation filter, preferably for a data receiver, which contains an analog-to-digital converter (2) and in which the digital signals are split up downstream of the analog-to-digital converter (2) and of a coarse filter (3) into a first path (A) and into a second path (B) by correspondingly assigned digital bandpass filters (4, 5), characterized in that the two bandpass filters (4, 5) are constructed as transverse filters (10, 11), in that these transverse filters (10, 11) are dimensioned in such a way that their coefficients are produced from the sum or from the difference of the coefficients of the two transverse bandpass filters (4, 5), and in that the two paths (A, B) are interconnected via a multiplier (12).

2. Digital separation filter according to Claim 1, characterized in that only one common state memory (w, delay line) is provided for both transverse bandpass filters (10, 11).

**Revendications**

1. Filtre séparateur numérique, notamment pour un récepteur de données, qui comporte un convertisseur analogique/numérique (2) et dans lequel les signaux numériques sont répartis, en aval du convertisseur analogique/numérique (2) et d'un préfiltre (3), entre une première voie (A) et une seconde voie (B), par des filtres passe-bande numériques (4,5) associés de façon correspondante, caractérisé par le fait que les deux filtres passe-bande (4,5) sont agencés sous la forme de filtres transversaux (10,11), et que ces filtres transversaux (10,11) sont dimensionnés de telle sorte que leurs coefficients sont déterminés à partir de la somme ou de la différence des coefficients des deux filtres passe-bande transversaux (4,5), et que les deux voies (A,B) sont interconnectées par l'intermédiaire d'un multiplicateur (12).

2. Filtre séparateur numérique suivant la revendication 1, caractérisé par le fait que pour les deux filtres passe-bande transversaux (10,11), il n'est prévu qu'une mémoire d'état commune (w, chaîne de retardement).

# FIG 1

# FIG 2

## FIG 3

## FIG 4